(19) Europäisches Patentamt
European Patent Office
Office européen des brevets

(11) **EP 3 717 921 B1**

(12) **FASCICULE DE BREVET EUROPEEN**

(45) Date de publication et mention de la délivrance du brevet:
**11.01.2023 Bulletin 2023/02**

(21) Numéro de dépôt: **18808351.3**

(22) Date de dépôt: **27.11.2018**

(51) Classification Internationale des Brevets (IPC):
**G01R 33/28** (2006.01)   **G01R 33/56** (2006.01)
**G01R 33/32** (2006.01)

(52) Classification Coopérative des Brevets (CPC):
**G01R 33/282; G01R 33/5601;** G01R 33/326

(86) Numéro de dépôt international:
**PCT/EP2018/082646**

(87) Numéro de publication internationale:
**WO 2019/105912 (06.06.2019 Gazette 2019/23)**

(54) **PROCÉDÉ ET APPAREIL D'HYPERPOLARISATION DE SPINS, NOTAMMENT ÉLECTRONIQUES**

VERFAHREN UND VORRICHTUNG ZUR HYPERPOLARISATION VON SPINS, INSBESONDERE VON ELEKTRONISCHEN SPINS

METHOD AND APPARATUS FOR HYPERPOLARISATION OF SPINS, IN PARTICULAR ELECTRONIC SPINS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **28.11.2017 FR 1761273**

(43) Date de publication de la demande:
**07.10.2020 Bulletin 2020/41**

(73) Titulaire: **Commissariat à l'Energie Atomique et aux Energies Alternatives**
**75015 Paris (FR)**

(72) Inventeur: **BERTET, Patrice**
**75013 Paris (FR)**

(74) Mandataire: **Atout PI Laplace**
**Immeuble "Visium"**
**22, avenue Aristide Briand**
**94117 Arcueil Cedex (FR)**

(56) Documents cités:
**US-A1- 2016 109 540**

- **GÖPPL M ET AL: "Coplanar Waveguide Resonators for Circuit Quantum Electrodynamics", ARXIV.ORG, CORNELL UNIVERSITY LIBRARY, 201 OLIN LIBRARY CORNELL UNIVERSITY ITHACA, NY 14853, 25 juillet 2008 (2008-07-25), XP080428417, DOI: 10.1063/1.3010859**
- **BENNINGSHOF O W B ET AL: "Superconducting microstrip resonator for pulsed ESR of thin films", JOURNAL OF MAGNETIC RESONANCE, ACADEMIC PRESS, ORLANDO, FL, US, vol. 230, 5 février 2013 (2013-02-05), pages 84-87, XP028546196, ISSN: 1090-7807, DOI: 10.1016/J.JMR.2013.01.010**
- **ZOLLITSCH CHRISTOPH W ET AL: "High cooperativity coupling between a phosphorus donor spin ensemble and a superconducting microwave resonator", APPLIED PHYSICS LETTERS, A I P PUBLISHING LLC, US, vol. 107, no. 14, 5 octobre 2015 (2015-10-05), XP012201078, ISSN: 0003-6951, DOI: 10.1063/1.4932658 [extrait le 1901-01-01]**
- **A. BIENFAIT ET AL: "Reaching the quantum limit of sensitivity in electron spin resonance", NATURE NANOTECHNOLOGY, vol. 11, no. 3, 14 décembre 2015 (2015-12-14), pages 253-257, XP055492571, GB ISSN: 1748-3387, DOI: 10.1038/nnano.2015.282 cité dans la demande**

- **A. BIENFAIT ET AL: "Controlling spin relaxation with a cavity", NATURE, vol. 531, no. 7592, 15 février 2016 (2016-02-15), pages 74-77, XP055492555, GB ISSN: 0028-0836, DOI: 10.1038/nature16944 cité dans la demande**
- **MARK C. BUTLER ET AL: "Polarization of nuclear spins by a cold nanoscale resonator", PHYSICAL REVIEW A (ATOMIC, MOLECULAR, AND OPTICAL PHYSICS), vol. 84, no. 6, 6 décembre 2011 (2011-12-06), XP055369758, USA ISSN: 1050-2947, DOI: 10.1103/PhysRevA.84.063407 cité dans la demande**

## Description

L'invention porte sur un procédé et un appareil d'hyperpolarisation de spins. Elle s'applique principalement à la spectroscopie par résonance paramagnétique électronique (RPE), mais également à la résonance magnétique nucléaire (RMN), à la recherche fondamentale en physique, à la spintronique (exploitation des propriétés quantiques des spins pour stocker et traiter de l'information) etc.

La résonance paramagnétique électronique (RPE), également dite résonance de spin électronique (RSE), désigne la propriété de certains électrons d'interagir de manière résonante avec un champ électromagnétique lorsqu'ils sont placés dans un champ magnétique stationnaire. Seuls les électrons non appariés présentent cette propriété. De tels électrons se trouvent dans les espèces chimiques radicalaires, ainsi que dans les sels et complexes d'éléments de transition.

Ainsi, la résonance paramagnétique électronique peut être utilisée comme technique spectroscopique pour mettre en évidence la présence d'électrons non appariés et d'en déterminer l'environnement chimique et physique.

Comme c'est également le cas en résonance magnétique nucléaire, l'intensité du signal de résonance paramagnétique électronique est proportionnelle à la polarisation moyenne de spin S, c'est-à-dire à la différence entre le nombre de spins parallèles et antiparallèles au champ magnétique stationnaire, rapportée au nombre total de spins. A l'équilibre thermique, la polarisation moyenne de spin est régie par la loi de Boltzmann et dépend donc de la température T de l'échantillon :

$$S_0 = Tanh\left(\frac{\hbar\omega_0}{2kT}\right)$$

où l'indice « 0 » désigne la valeur d'équilibre thermique de la polarisation moyenne de spin S, « Tanh » est la fonction tangente hyperbolique, $\omega_0$ est la fréquence de résonance paramagnétique électronique (fréquence de Larmor) - et donc $\hbar\omega_0$ est la différence d'énergie entre les deux niveaux énergétiques correspondant aux deux orientations possibles des spins électroniques - k est la constante de Boltzmann et T la température en Kelvin. La fréquence de Larmor $\omega_0$ est donnée par $\omega_0 = \gamma B_0$ où $\gamma$ est le rapport gyromagnétique et $B_0$ l'intensité du champ magnétique stationnaire.

Afin de maximiser l'intensité du signal RPE, et donc la sensibilité de la détection, il est donc nécessaire de minimiser la température T et/ou de maximiser l'intensité du champ magnétique $B_0$, de telle sorte que $\hbar\omega_0$ = $\gamma B_0$ > $kT$. Par exemple pour un spectromètre bande X (travaillant à $\omega_0/2\pi$=9 GHz) à une température de T=2 K, la polarisation moyenne est de $S_0$=0,1. Si l'on souhaitait atteindre une polarisation proche de 1, il faudrait abaisser la température de l'échantillon en-dessous de 0,3 K, ce qui est beaucoup plus coûteux technologiquement et financièrement. De même, il existe des limites technologiques à l'intensité du champ magnétique, et il est par ailleurs difficile d'augmenter la fréquence de résonance au-delà de quelques dizaines de GHz.

Une autre motivation pour augmenter la polarisation d'un ensemble de spins électroniques est que cette polarisation peut être transférée à des spins nucléaires : on parle de Polarisation Nucléaire Dynamique (DNP). La DNP est une technique essentielle pour un grand nombre d'applications en Résonance Magnétique Nucléaire (RMN). On se heurte là à la même difficulté mentionnée plus haut, c'est-à-dire à la nécessité de refroidir l'échantillon contenant les spins à polariser à des températures extrêmement basses.

L'invention vise à surmonter ces inconvénients de l'art antérieur. Plus particulièrement elle vise à procurer une méthode simple, économique et efficace pour augmenter la polarisation d'un ensemble de spins. Bien qu'une application de l'invention aux spins électroniques soit considérée de manière préférentielle, la méthode s'applique également aux spins nucléaires. Ces derniers présentent cependant un rapport gyromagnétique plus faible que celui des électrons de deux ou trois ordres de grandeur, ce qui rend la mise en œuvre de l'invention plus contraignante.

Conformément à l'invention, ce but est atteint en hyperpolarisant les spins (c'est-à-dire en rendant la polarisation moyenne S supérieure à sa valeur d'équilibre $S_0$) par refroidissement radiatif. Plus particulièrement, l'hyperpolarisation est obtenue en couplant fortement les spins de l'échantillon à un résonateur supportant un champ électromagnétique à la fréquence de Larmor dont la température effective est inférieure à la température physique du résonateur. Plusieurs techniques, qui seront décrites dans la suite, permettent d'atteindre cette condition. On entend par température effective (ou « photonique ») d'un champ électromagnétique dans un résonateur de fréquence de résonance $\omega/2\pi$ la valeur $T_{eff}$ telle que le nombre moyen $n_{ph}$ de photons de fréquence $\omega/2\pi$ dans le résonateur soit donné par :

$$n_{ph} = \frac{1}{exp\left(\frac{\hbar\omega}{kT_{eff}}\right) - 1}$$

En d'autres termes,

$$T_{eff} = \left[\frac{k}{\hbar\omega} ln\left(1 + \frac{1}{n_{ph}}\right)\right]^{-1}$$

En refroidissant le champ au lieu de refroidir l'échantillon, ou le résonateur, on limite fortement le recours à des techniques de cryogénie, complexes et couteuses.

Un objet de l'invention est donc un procédé d'hyperpolarisation de spins tel que défini par la revendication 1 comprenant les étapes suivantes :

a) placer un échantillon contenant des spins dans un champ magnétique stationnaire ;
b) coupler magnétiquement l'échantillon à un résonateur électromagnétique présentant une fréquence de résonance $\omega_0$ égale à la fréquence de Larmor des spins dans le champ magnétique stationnaire, la force du couplage et le facteur de qualité du résonateur étant suffisamment élevés pour que le couplage avec le résonateur domine la dynamique de relaxation des spins ; et
c) réduire la température effective du champ électromagnétique à l'intérieur du résonateur électromagnétique au-dessous de sa température physique et de celle de l'échantillon ;

moyennant quoi la polarisation des spins de l'échantillon s'établit à une valeur supérieure à sa valeur d'équilibre thermique.

Selon des modes de réalisation particuliers de l'invention :

- L'étape c) peut comprendre le sur-couplage du résonateur électromagnétique à une résistance maintenue à une température inférieure à celle du résonateur électromagnétique et à celle de l'échantillon.
- Alternativement, l'étape c) peut comprendre le couplage du résonateur électromagnétique à un résonateur électromagnétique auxiliaire présentant une fréquence de résonance $\omega_1$ et un taux d'amortissement plus élevés, la force du couplage étant modulée à une fréquence $\omega_c=\omega_1-\omega_0$. Dans ce cas, le couplage du résonateur électromagnétique au résonateur électromagnétique auxiliaire peut notamment être assuré par un dispositif de type SQUID comprenant une boucle traversée par un champ magnétique modulé à la fréquence $\omega_c$, ou bien par une jonction Josephson excitée par deux signaux électromagnétiques ayant des fréquences respectives dont la différence est égale à $\omega_c$. En outre, le résonateur électromagnétique auxiliaire peut être couplé à une résistance.
- Le résonateur électromagnétique peut être de type supraconducteur et présenter des dimensions micrométriques ou sub-micrométriques. Il est alors préférentiellement réalisé en technologie planaire.
- Les spins peuvent en particulier être des spins électroniques.

Un autre objet de l'invention est l'utilisation d'un tel procédé pour polariser un ensemble de spins nucléaires par polarisation nucléaire dynamique.

Encore un autre objet de l'invention est un appareil d'hyperpolarisation de spins comprenant :

- une source d'un champ magnétique stationnaire ;
- un résonateur électromagnétique pouvant être couplé à un échantillon contenant des spins et pouvant être immergé dans le champ magnétique stationnaire, le résonateur électromagnétique présentant une fréquence de résonance $\omega_0$ égale à la fréquence de Larmor des spins de l'échantillon dans le champ magnétique stationnaire, la force du couplage et le facteur de qualité du résonateur étant suffisamment élevés pour que le couplage avec le résonateur domine la dynamique de relaxation des spins de l'échantillon ; et
- un dispositif permettant de réduire la température effective du champ électromagnétique à l'intérieur du résonateur électromagnétique au-dessous de sa température physique.

Selon des modes de réalisation particuliers d'un tel appareil :

- Le dispositif permettant de réduire la température effective du champ électromagnétique à l'intérieur du résonateur électromagnétique au-dessous de sa température physique peut comprendre une résistance, un cryostat pour maintenir ladite résistance à une température inférieure à celle du résonateur électromagnétique et un élément de connexion sur-couplant la résistance au résonateur électromagnétique.
- En variante, le dispositif permettant de réduire la température effective du champ électromagnétique à l'intérieur du résonateur électromagnétique au-dessous de sa température physique peut comprendre un résonateur électromagnétique auxiliaire présentant une fréquence de résonance $\omega_1$ et un taux d'amortissement plus élevés que ceux du résonateur électromagnétique, et un dispositif de couplage pour coupler les résonateur électromagnétique et le résonateur électromagnétique auxiliaire avec une force de couplage modulée à une fréquence $\omega_c=\omega_1-\omega_0$. Le dispositif de couplage peut comprendre un dispositif de type SQUID ayant une boucle, et une source de champ magnétique alternatif pour générer un champ magnétique modulé à la fréquence $\omega_c$ traversant ladite boucle, ou bien une jonction Josephson et deux sources de signaux électromagnétiques ayant des fréquences respectives dont la différence est égale à $\omega_c$, agencées de manière à exciter ladite jonction Josephson. En outre l'appareil peut comprendre également une résistance couplée au résonateur électromagnétique auxiliaire.
- Le résonateur électromagnétique peut être de type supraconducteur et présenter des dimensions micrométriques ou sub-micrométriques. Il est alors préférentiellement réalisé en technologie planaire.

D'autres caractéristiques, détails et avantages de l'invention ressortiront à la lecture de la description faite en référence aux dessins annexés donnés à titre d'exemple et qui représentent, respectivement :

- la figure 1, un appareil selon un premier mode de réalisation de l'invention ;
- la figure 2, un appareil selon un deuxième mode de réalisation de l'invention ;
- les figures 3A et 3B, deux dispositifs de couplage pouvant être utilisés dans des variantes respectives de l'appareil de la figure 2 ; et
- la figure 4, un résonateur électromagnétique pouvant être utilisé dans les appareils des figures 1 et 2.

L'invention repose sur un effet connu sous le nom de « effet Purcell de spin ». L'effet Purcell est l'augmentation du taux d'émission spontanée par un système quantique excité obtenu par couplage avec une cavité résonance accordée à la fréquence de la transition. Cet effet a été proposé en 1946 par E. M. Purcell, qui s'intéressait au comportent d'un ensemble de spins nucléaires dans un champ magnétique. Cependant, il a principalement été observé et étudié dans le domaine de la fluorescence optique. L'effet Purcell de spin n'a en fait été observé qu'en 2016 par les présents inventeurs et leurs collaborateurs [1], qui l'ont appliqué pour accélérer le retour à l'équilibre thermique de spins électroniques dans un spectromètre RPE [2]. Dans le cadre de l'invention, cependant, cet effet est utilisé dans un but tout à fait différent, c'est-à-dire celui d'obtenir une polarisation de spin supérieure à celle d'équilibre thermique. En d'autres termes, alors que dans [1] et [2] l'effet Purcell de spin était utilisé pour amener une population de spins à l'équilibre, dans l'invention ce même effet permet d'amener une telle population hors équilibre.

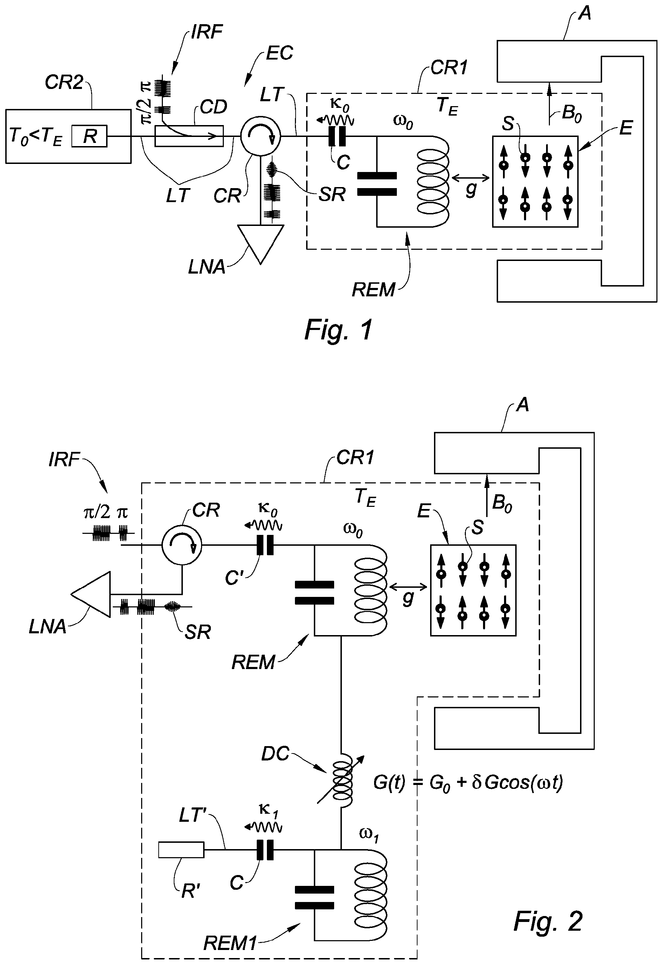

La figure 1 montre un appareil selon un premier mode de réalisation de l'invention.

Un échantillon E contenant des spins électroniques non appariés (représentés symboliquement par la référence s) est immergé dans un champ magnétique stationnaire $B_0$, uniforme à l'échelle de l'échantillon, généré par un aimant A. Les spins sont couplés magnétiquement à un résonateur microondes REM (modélisé par un circuit résonant LC) accordé à la fréquence de Larmor des spins $\omega_0 = \gamma B_0$ (dans la suite, dans un souci de simplicité, on appellera « fréquence » la « fréquence angulaire » ou « pulsation »). L'ensemble constitué par l'échantillon et le résonateur est maintenu à une température $T_E$, qui est généralement inférieure à la température ambiante (293 K) est de préférence comprise entre 10 mK et 10 K, par exemple en le plaçant dans un cryostat CR1, ou simplement un vase de Dewar contenant un fluide cryogénique. Cette température n'est pas suffisamment basse pour obtenir la polarisation moyenne voulue.

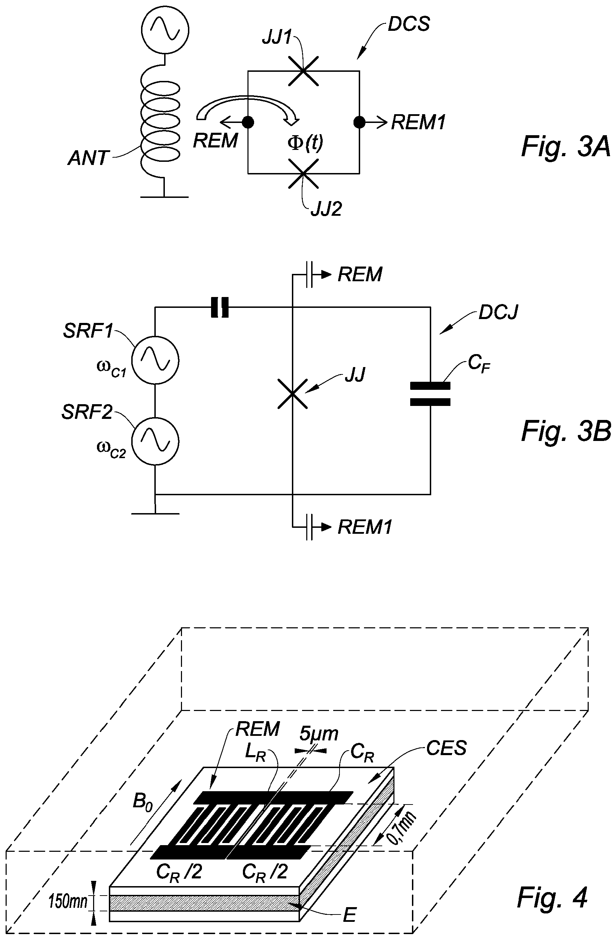

Il est important que les spins se trouvent dans ce qu'on peut appeler le « régime Purcell », dans lequel ils sont plus fortement couplés aux photons du résonateur REM qu'aux phonons de l'échantillon, la dynamique de relaxation étant donc dominé par le couplage avec le résonateur plutôt que par le couplage thermique à l'échantillon. D'une manière plus quantitative, on note g la « constante de couplage spins-résonateur », définie comme la moitié de la fréquence de Rabi d'un spin lorsque un photon micro-onde est présent dans le résonateur ; on note κ le taux d'amortissement de l'énergie micro-onde stockée dans le résonateur, relié au facteur de qualité Q du résonateur par $\kappa_0 = \omega_0/Q$ ; on note $TR_P$ le « temps de relaxation Purcell » défini comme $TR_P = \kappa_0/(4g^2)$ et $TR_1$ le temps de relaxation des spins dû au couplage avec les phonons. Le régime Purcell est alors défini comme le régime où $TR_P \ll TR_1$ (par exemple $TR_1 \geq 10 TR_P$). Pour que cette condition puisse être satisfaite il est nécessaire de maximiser à la fois la constante de couplage g et le facteur de qualité Q du résonateur. Pour maximiser la constante de couplage g il convient de miniaturiser le résonateur, qui doit de préférence avoir au moins deux dimensions micrométriques ou sub-micrométriques (inférieures à 100 μm et de préférence à 1 μm). Pour maximiser le facteur de qualité Q il convient d'utiliser un résonateur supraconducteur. Une réalisation concrète d'un résonateur permettant d'atteindre le régime de Purcell est décrite dans la référence [1] et ci-après en référence à la figure 4. Ce même résonateur avait déjà été utilisé pour une technique de spectroscopie RPE à haute sensibilité : voir les références [5] et [6].

Dans le régime Purcell, la valeur de la polarisation moyenne des spins est déterminée par le nombre moyen « n » de photons dans le résonateur. Dans le cas où le champ micro-onde à l'intérieur du résonateur est à la température de l'échantillon $T_E$, le nombre moyen de photons vaut $n_{th} = 1/(\exp(\hbar\omega_0 / kT_E)-1)$, où l'indice « th » rappelle que cette condition correspond à l'équilibre thermique. Il serait possible, en principe, d'augmenter la polarisation moyenne des spins au-dessus de sa valeur d'équilibre thermique en refroidissant le résonateur au-dessous de la température de l'échantillon, mais cela n'est ni facile ni avantageux. Ainsi, conformément à l'invention l'on propose de baisser le nombre moyen de photons dans le résonateur au-dessous de sa valeur d'équilibre thermique.

Dans le mode de réalisation de la figure 1, que l'on peut qualifier de « passif », cela est obtenu en couplant le résonateur REM à une résistance R qui est, elle, maintenue à une température $T_0$ inférieure - et de préférence très inférieure, par exemple d'un facteur 10 (en Kelvins) ou plus - à celle ($T_E$) de l'ensemble échantillon-résonateur. Pour cela, la résistance R est placée dans un cryostat CR2. Le couplage entre le résonateur et la résistance peut être assuré par un simple guide d'onde ou ligne de transmission - par exemple planaire ou coaxiale - telle que la résistance R constitue une charge adaptée. Typiquement, on choisira donc une résistance R de valeur égal à 50 Ω, qui est l'impédance caractéristique de la plupart des câbles coaxiaux du commerce. Dans le cas de la figure 1, cependant, l'élément de connexion EC est plus complexe et comprend, en plus d'une ligne de transmission LT, une capacité de découplage C montée en série ainsi qu'un circulateur CR et un coupleur directionnel CD. Le coupleur directionnel permet d'injecter des impulsions radiofréquence IRF d'excitation des spins nucléaires (par exemple une impulsion « π/2 » suivie d'une impulsion « π »), et le circulateur d'extraire un signal de réponse SR des spins nucléaires pour le transmettre à une chaine d'acquisition (la référence LNA désigne un amplificateur à bas bruit de cette chaîne).

Il est important que le résonateur REM soit « sur-couplé » à la résistance R, c'est-à-dire que l'amortissement du champ dans la cavité se fasse essentiellement par fuite du champ vers la résistance via l'élément de couplage. De manière plus quantitative le résonateur est sur-couplé si le taux auquel se produit l'absorption de l'énergie stockée dans la cavité à cause de pertes internes $\kappa_i$ est très inférieur (par exemple d'un facteur 10 ou plus) au taux d'amortissement total $\kappa_0$. Dans ces conditions, le nombre moyen de photons dans le résonateur s'établira à une valeur $n_{low}$ inférieure à celle d'équilibre thermique, et proche de celle qui correspondrait à une température $T_0$: $n_{low} \approx 1/(\exp(\hbar\omega_0 / kT_0)-1)$.

On dit alors que le champ a été refroidi à une température effective $T_{eff}$ proche de celle de la résistance R ($T_{eff}\approx T_0$), alors même que la température « physique » du résonateur reste égale à $T_E>>T_0$. Cela produit l'hyperpolarisation recherchée. Plus exactement la polarisation de spin atteint alors la valeur $S'=1/(1+2n_{low})$. L'augmentation de la polarisation de spin par effet Purcell est donc donnée par le facteur $(1+2n_{th})/(1+2n_{low})$.

L'appareil de la figure 1 est avantageux car il ne nécessite pas de refroidir l'échantillon, ni le résonateur, mais uniquement une résistance qui peut être éloignée de ce dernier. Néanmoins, le refroidissement de la résistance à une température $T_0$ qui est typiquement de l'ordre de quelques milliKelvin nécessite la mise en œuvre de moyens de cryogénie assez sophistiqués. Le mode de réalisation de la figure 2, que l'on peut qualifier de refroidissement « actif » du champ électromagnétique, permet d'éliminer tout recours à de tels moyens.

Comme dans le cas de la figure 1, un échantillon E contenant des spins électroniques non appariés s est immergé dans un champ magnétique stationnaire $B_0$, uniforme à l'échelle de l'échantillon, généré par un aimant A. Les spins sont couplés magnétiquement à un premier résonateur microondes REM (modélisé par un circuit résonant LC) accordé à la fréquence de Larmor des spins $\omega_0 = \gamma B_0$, de telle sorte que le système se trouve en régime Purcell, tel que défini plus haut. Le premier résonateur est couplé à un deuxième résonateur microondes REM1, ou résonateur auxiliaire (également modélisé par un circuit résonant LC), accordé à une fréquence $\omega_1$ supérieure à $\omega_0$, de préférence d'au moins un facteur 10. En outre, le taux d'amortissement $\kappa_1$ du deuxième résonateur REM1 doit être très supérieur (de préférence d'au moins un facteur 10) à celui, $\kappa_0$, du premier résonateur. Cela est obtenu en couplant le deuxième résonateur à une résistance R' par l'intermédiaire d'une ligne de transmission LT' ou d'un guide d'onde d'impédance adaptée, et d'une capacité en série C. L'injection des signaux d'excitation des spins et l'extraction du signal de réponse se font, par exemple, par l'intermédiaire du circulateur CR relié au premier résonateur par une capacité en série C'.

Le premier et le deuxième résonateur sont couplés par un dispositif de couplage DC présentant une force de couplage G modulée temporellement à une fréquence $\omega_c$ égale (avec une erreur de préférence non supérieure à la somme des largeurs spectrales des deux résonateurs) à la différence entre les fréquences de résonance des deux résonateurs : $\omega_c=\omega_1-\omega_0$. On peut par exemple considérer une modulation sinusoïdale $G(t)=G_0+\delta G\cdot\cos(\omega_c t)$.

La force du couplage G représente la fréquence à laquelle l'énergie d'un résonateur serait transmise à l'autre, s'ils étaient placés à la même fréquence.

L'ensemble constitué par l'échantillon, les deux résonateurs, la résistance et le dispositif de couplage est maintenu à une température $T_E$, qui est généralement inférieure à la température ambiante (293 K) et de préférence comprise entre 10 mK et 10 K, par exemple en le plaçant dans un cryostat CR1, ou simplement un vase de Dewar contenant un fluide cryogénique.

Il est possible de montrer que, dans ces conditions, le nombre moyen de photons dans les deux résonateurs tend à l'égalité (voir [3], qui expose la théorie du refroidissement actif d'un nano-oscillateur mécanique). Or, étant donné que $\omega_1>>\omega_0$, pour une température donnée le nombre moyen de photons dans le deuxième résonateur est très inférieur que dans le premier résonateur (c'est une conséquence directe de la statistique de Bose-Einstein).

Plus précisément, il est possible de montrer que, sous l'action du couplage au deuxième résonateur, le premier résonateur voit son taux d'amortissement augmenter à un taux induit $\kappa_{ind} = \kappa_0 + 4\delta G^2 /\kappa_1$, et que le nombre de photons en régime permanent dans le premier résonateur devient $n_{low} = [n_{th0}\kappa_0 + n_{th1}\kappa_{ind}]/(\kappa_0 + \kappa_{ind})$ où $n_{th0}$ et $n_{th1}$ sont les nombre moyens de photons dans le premier et le deuxième résonateurs à l'équilibre thermique à la température $T_E$.

Ce résultat est valable si $\delta G < \kappa_1 < \omega_0$, ce qui correspond à ce qu'on appelle la « limite de bande latérale résolue ». Cela correspond à une situation dans laquelle les bandes latérales générées par la modulation du couplage autour de la fréquence $\omega_1$ sont à une différence de fréquence supérieure à la largeur spectrale du signal d'oscillation du second résonateur. L'on suppose ici que cette condition est satisfaite. Plus particulièrement, la méthode fonctionne de manière optimale lorsque $\delta G >> \sqrt{\kappa_0\kappa_1}$ (par exemple $\delta G \geq 10\sqrt{\kappa_0\kappa_1}$). Dans ce cas, le taux d'amortissement induit du premier résonateur $\kappa_{ind}$ est très supérieur à son taux « naturel »

$\kappa_0$ et l'on obtient $n_{low} \approx n_{th0} (\kappa_0 / \kappa_{ind}) + n_{th1}$. Selon les paramètres choisis, le nombre de photons dans le premier résonateur peut être réduit par jusqu'à deux ordres de grandeur. Cela se traduira directement par une augmentation de deux ordres de grandeur de la polarisation des spins S et donc du signal d'écho de spin.

Il a été indiqué plus haut que la méthode ne marche que si la condition de régime Purcell, $TR_P \gg TR_1$ est vérifiée. Or, il faut tenir compte du fait que la modulation du couplage mène à une augmentation de l'amortissement effectif du premier résonateur $\kappa_{ind}$, et donc à un allongement effectif du temps de relaxation Purcell. Pour que les spins se trouvent en régime Purcell il est donc nécessaire que $\kappa_{ind}/(4g^2) \ll TR_1$, ou encore $(\delta G/g)^2 \ll TR_1 \kappa_1$. En d'autres termes, par rapport au premier mode de réalisation, il est encore plus important de maximiser la constante de couplage spins-résonateur en miniaturisant ce dernier.

Différents modes de réalisation du dispositif de couplage DC peuvent être utilisés dans le cadre de l'invention.

Dans l'exemple de la figure 3A, les résonateurs REM et REM1 sont connectés - éventuellement par l'intermédiaire d'une capacité respective - aux deux bornes d'un dispositif DCS de type SQUID (de l'anglais « Superconducting Quantum Interference Device », c'est-à-dire dispositif supraconducteur à interférence quantique) comprenant deux jonctions Josephson JJ1 et JJ2 formant une boucle. Une antenne ANT (par exemple une simple inductance) est agencée à proximité du dispositif, alimentée par un générateur radiofréquence à la fréquence $\omega_c$, génère un champ magnétique, et donc un flux magnétique $\Phi(t)$ à travers la boucle, variables à cette même fréquence. Le flux magnétique peut éventuellement présenter aussi une composante constante.

Dans l'exemple de la figure 3B, les résonateurs REM et REM1 sont connectés - par l'intermédiaire d'une capacité respective - aux deux bornes d'une jonction Josephson JJ excitée par deux signaux à des fréquences respectives $\omega_{c1}$, $\omega_{c2}$ telles que $|\omega_{c1}-\omega_2|=\omega_c$. Par exemple, ces signaux sont fournis, via un couplage capacitif, par deux générateurs de tension à radiofréquence SRF1, SRF2 connectés en série. Une capacité $C_F$ peut être connectée en parallèle à la jonction Josephson pour baisser sa fréquence de résonance naturelle. On désigne par la référence DCJ le dispositif de couplage comprenant la jonction Josephson JJ, les générateurs SRF1, SRF2, les capacités de couplage et, le cas échéant, la capacité $C_F$.

La figure 4 montre un dispositif intégrant à la fois l'échantillon E et le premier résonateur REM. L'échantillon, utilisé dans un but de démonstration de la technique, est constitué par une couche d'atomes de bismuth (Bi) implantés, à une profondeur de 150 nm, dans une couche épitaxiale CES de silicium 28 ($^{28}$Si, obtenu par enrichissement isotopique, de manière à supprimer les perturbations induites par le spin nucléaire de l'isotope $^{29}$Si). Le bismuth étant un élément du group V, chaque atome implanté donne un électron « libre » au cristal de silicium; les spins devant être polarisés sont ceux de ces électrons. Un résonateur LC planaire, REM, est réalisé à la surface de la couche épitaxiale par dépôt et gravure d'une couche d'aluminium, qui devient supraconducteur au-dessous de 1,2 K. Le résonateur REM est constitué par une capacité interdigité $C_R$ et une inductance $L_R$. La capacité $C_R$ est formée par deux pistes conductrices parallèles principales, à partir desquelles s'étendent des « doigts » conducteurs perpendiculaires aux pistes. Les doigts qui se départent d'une piste s'intercalent entre ceux qui se départent de l'autre piste. L'inductance $L_R$ est constituée par une piste conductrice rectiligne qui relie les deux pistes principales de la capacité. Elle est agencée dans la partie centrale du résonateur, de telle sorte qu'elle partage la capacité $C_R$ en deux parties symétriques ($C_R/2$), connectées en parallèle. Le résonateur est inséré dans un boîtier en cuivre BC (représenté en trait pointillé) pour supprimer les pertes radiatives. Des signaux à radiofréquence sont injectés et extraits par des antennes asymétriques (non représentées). Le champ magnétique $B_0$ est parallèle à l'inductance. L'ensemble est maintenu à une température de 12 mK.

Avec huit paires de doigts de 700 $\mu$m de longueur et une inductance de 5 $\mu$m de largeur, le résonateur REM présente une fréquence de résonance de 7,24 GHz et un facteur de qualité chargé de $3 \cdot 10^5$ à cette même fréquence.

Dans une application de la technique à la spectroscopie par résonance paramagnétique électronique, l'échantillon sera par exemple constitué par une goutte de solution à analyser déposée sur le résonateur planaire (avec, si nécessaire, interposition d'une couche mince de passivation/isolation électrique).

L'invention a été décrite en faisant principalement référence à son application à la spectroscopie par résonance paramagnétique électronique, mais elle s'applique plus généralement à toute situation dans laquelle il est avantageux d'augmenter la polarisation d'un ensemble de spins au-delà de l'équilibre thermique. Par exemple, la polarisation d'un ensemble de spins électroniques est aussi utilisée en Polarisation Nucléaire Dynamique (DNP), pour polariser en retour un ensemble de spins nucléaires. L'invention peut donc être appliquée à la Polarisation Nucléaire Dynamique. Pour ce faire, on dispose à proximité immédiate du résonateur REM une substance qui contient à la fois des spins électroniques non appariés et des spins nucléaires. Les spins électroniques sont polarisés conformément à l'invention ; un champ électromagnétique de fréquence égale à la différence entre les fréquences de Larmor des spins électroniques et nucléaires induit un couplage entre ces derniers, et transfère la polarisation aux spins nucléaires. Voir [7] pour plus de détails.

L'invention n'est d'ailleurs pas limitée à l'hyperpolarisation des spins électroniques. Elle peut également s'appliquer directement au cas des spins nucléaires.

Néanmoins cela est plus difficile car, pour les spins nucléaires, la constante de couplage spins-résonateur g est plus faible d'un facteur $10^3$ environ par rapport au cas électronique, et donc le temps de relaxation Purcell est plus élevé d'un facteur $10^6$. En outre, pour un champ magnétique donné, les fréquences de Larmor des spins nucléaires sont plus basses, et donc les polarisations d'équilibre sont plus faibles.

D'autres méthodes permettant de « refroidir » le champ électromagnétique à l'intérieur d'un résonateur peuvent être envisagées et utilisées dans le cadre de la présente invention.

Seul le cas d'un résonateur électromagnétique supraconducteur de type planaire a été considéré, mais d'autres technologies peuvent être utilisées, par exemple des résonateurs à cavité. Le dimensionnement est donné uniquement à titre d'exemple.

En ce qui concerne le mode de réalisation à refroidissement actif, deux dispositifs de couplage ont été décrits en détails, mais il ne s'agit là que d'exemples donnés à titre non limitatif.

Références

[1] « Controlling Spin Relaxation with a Cavity », A. Bienfait, J.J. Pla, Y. Kubo, X. Zhou, M. Stern, C.C Lo, C.D. Weis, T. Schenkel, D. Vion, D. Esteve, J.J.L. Morton, P. Bertet, Nature 531, 74 (2016)

[2] « Polarization of nuclear spins by a cold nanoscale resonator », Mark C. Butle, Daniel P. Weitekamp, Phys. Rev. A 84, 063407

[3] « Quantum Theory of Cavity-Assisted Sideband Cooling of Mechanical Motion », Florian Marquardt, Joe P. Chen, A. A. Clerk, S. M. Girvin, Phys. Rev. Lett. 99, 093902

[4] « Controlled release of multiphoton quantum states from a microwave cavity memory », W. Pfaff, C.J. Axline, L. D. Burkhart, U. Vool, P. Reinhold, L. Frunzio, L. Jiang, M. H. Devoret, R.J. Schoelkopf, Nature Physics 13, 882-887 (2017)

[5] « Reaching the quantum limit of sensitivity in electron spin resonance » Bienfait, A., Pla, J. J., Kubo, Y., Stern, M., Zhou, X., Lo, C. C. , Esteve, D. (2016). Nature nanotechnology, 11(3), 253-257.

[6] WO 2016/139419

[7] A. Abragam, M. Goldman, « Principles of dynamic nuclear polarisation », Reports on Progress in Physics 41, 395 - 467 (1978).

Revendications

1. Procédé d'hyperpolarisation de spins comprenant les étapes suivantes :

   a) placer un échantillon (E) contenant des spins (s) dans un champ magnétique stationnaire ($B_0$);
   b) coupler magnétiquement l'échantillon à un résonateur électromagnétique (REM) configuré pour présenter une fréquence de résonance $\omega_0$ égale à la fréquence de Larmor des spins dans le champ magnétique stationnaire, la force du couplage et le facteur de qualité du résonateur étant suffisamment élevés pour que le couplage avec le résonateur domine la dynamique de relaxation des spins ; et
   c) réduire la température effective

   $$T_{eff} = \left[\frac{k}{\hbar\omega_0} ln\left(1 + \frac{1}{n_{ph}}\right)\right]^{-1} du$$

   champ électromagnétique à l'intérieur du résonateur électromagnétique au-dessous de sa température physique et de celle de l'échantillon, $k$ étant la constante de Boltzmann, $\hbar$ la constante de Planck réduite et $n_{ph}$ le nombre moyen de photons de fréquence $\omega_0$ dans le résonateur ;

   moyennant quoi la polarisation des spins de l'échantillon s'établit à une valeur supérieure à sa valeur d'équilibre thermique.

2. Procédé selon la revendication 1 dans lequel l'étape c) comprend le sur-couplage du résonateur électromagnétique à une résistance (R) maintenue à une température inférieure à celle du résonateur électromagnétique et à celle de l'échantillon.

3. Procédé selon la revendication 1 dans lequel l'étape c) comprend le couplage du résonateur électromagnétique à un résonateur électromagnétique auxiliaire (REM1) configuré pour présenter une fréquence de résonance $\omega_1$ et un taux d'amortissement plus élevés, la force du couplage étant modulée à une fréquence $\omega_c = \omega_1 - \omega_0$.

4. Procédé selon la revendication 3 dans lequel le couplage du résonateur électromagnétique au résonateur électromagnétique auxiliaire est assuré par un dispositif de type SQUID (DCS) comprenant une boucle traversée par un champ magnétique modulé à la fréquence $\omega_c$.

5. Procédé selon la revendication 3 dans lequel le couplage du résonateur électromagnétique au résonateur électromagnétique auxiliaire est assuré par une jonction Josephson (JJ) excitée par deux signaux électromagnétiques ayant des fréquences respectives dont la différence est égale à $\omega_c$.

6. Procédé selon l'une des revendications 3 à 5 dans lequel le résonateur électromagnétique auxiliaire est couplé à une résistance (R').

7. Procédé selon l'une des revendications précédentes dans lequel le résonateur électromagnétique (REM) est de type supraconducteur et présente des dimensions micrométriques ou sub-micrométriques.

8. Procédé selon la revendication 7 dans lequel le résonateur électromagnétique est réalisé en technologie planaire.

9. Procédé selon l'une des revendications précédentes dans lequel les spins sont des spins électroniques.

10. Utilisation d'un procédé selon la revendication 9 pour polariser un ensemble de spins nucléaires par polarisation nucléaire dynamique.

11. Appareil d'hyperpolarisation de spins comprenant :

- une source (A) configurée pour générer un champ magnétique stationnaire ($B_0$) ;
- un résonateur électromagnétique (REM) configuré pour être couplé à un échantillon (E) contenant des spins (s) et être immergé dans le champ magnétique stationnaire, le résonateur électromagnétique étant configuré pour présenter une fréquence de résonance $\omega_0$ égale à la fréquence de Larmor des spins de l'échantillon dans le champ magnétique stationnaire, la force du couplage et le facteur de qualité du résonateur étant suffisamment élevés pour que le couplage avec le résonateur domine la dynamique de relaxation des spins de l'échantillon ; et
- un dispositif étant configuré pour réduire la température effective

$$T_{eff} = \left[\frac{k}{\hbar\omega_0} \ln\left(1 + \frac{1}{n_{ph}}\right)\right]^{-1}$$

du champ électromagnétique à l'intérieur du résonateur électromagnétique au-dessous de sa température physique, $k$ étant la constante de Boltzmann, $\hbar$ la constante de Planck réduite et $n_{ph}$ le nombre moyen de photons de fréquence $\omega_0$ dans le résonateur.

12. Appareil selon la revendication 11 dans lequel le dispositif configuré pour réduire la température effective du champ électromagnétique à l'intérieur du résonateur électromagnétique au-dessous de sa température physique comprend une résistance (R), un cryostat (CR2) configuré pour maintenir ladite résistance à une température ($T_0$) inférieure à celle ($T_E$) du résonateur électromagnétique et un élément de connexion (EC) configuré pour sur-coupler la résistance au résonateur électromagnétique.

13. Appareil selon la revendication 11 dans lequel le dispositif configuré pour réduire la température effective du champ électromagnétique à l'intérieur du résonateur électromagnétique au-dessous de sa température physique comprend un résonateur électromagnétique auxiliaire (REM1) configuré pour présenter une fréquence de résonance $\omega_1$ et un taux d'amortissement plus élevés que ceux du résonateur électromagnétique, et un dispositif de couplage (DC, DCS, DCJ) configuré pour coupler les résonateur électromagnétique et le résonateur électromagnétique auxiliaire avec une force de couplage modulée à une fréquence $\omega_c = \omega_1 - \omega_0$.

14. Appareil selon la revendication 13 dans lequel le dispositif de couplage (DCS) comprend un dispositif de type SQUID (DCS) ayant une boucle, et une source (ANT) de champ magnétique alternatif configuré pour générer un champ magnétique modulé à la fréquence $\omega_c$ traversant ladite boucle.

15. Appareil selon la revendication 13 dans lequel le dispositif de couplage (DCJ) comprend une jonction Josephson (JJ) et deux sources de signaux électromagnétiques (SRF1, SRF2) ayant des fréquences respectives dont la différence est égale à $\omega_c$, agencées de manière à exciter ladite jonction Josephson.

16. Appareil selon l'une des revendications 13 à 15 comprenant également une résistance (R') couplée au résonateur électromagnétique auxiliaire.

17. Appareil selon l'une des revendications 11 à 16 dans lequel le résonateur électromagnétique (REM) est de type semi-conducteur et présente des dimensions micrométriques ou sub-micrométriques.

18. Appareil selon la revendication 17 dans lequel le résonateur électromagnétique est réalisé en technologie planaire.

**Patentansprüche**

1. Verfahren zum Hyperpolarisieren von Spins, das die folgenden Schritte umfasst:

a) Platzieren einer Spins (s) enthaltenden Probe (E) in einem stationären Magnetfeld ($B_0$);
b) magnetisches Koppeln der Probe mit einem elektromagnetischen Resonator (REM), der so konfiguriert ist, dass er eine Resonanzfrequenz

$\omega_0$ von gleich der Larmorfrequenz der Spins in dem stationären Magnetfeld hat, wobei die Stärke der Kopplung und der Qualitätsfaktor des Resonators ausreichend hoch sind, damit die Kopplung mit dem Resonator die Relaxationsdynamik der Spins dominiert; und

c) Reduzieren der effektiven Temperatur

$$T_{eff} = \left[ \frac{k}{\hbar\omega_0} ln\left(1 + \frac{1}{n_{ph}}\right) \right]^{-1}$$

des elektromagnetischen Feldes im Inneren des elektromagnetischen Resonators unter seine physikalische Temperatur und die der Probe, wobei $k$ die Boltzmann-Konstante, h die reduzierte Planck-Konstante und $n_{ph}$ die mittlere Anzahl von Photonen der Frequenz $\omega_0$ im Resonator ist;

wodurch die Polarisation der Spins der Probe auf einen Wert eingestellt wird, der größer als ihr thermischer Gleichgewichtswert ist.

2. Verfahren nach Anspruch 1, wobei Schritt c) das Überkoppeln des elektromagnetischen Resonators mit einem Widerstand (R) umfasst, der auf einer Temperatur unter der des elektromagnetischen Resonators und der der Probe gehalten wird.

3. Verfahren nach Anspruch 1, wobei Schritt c) das Koppeln des elektromagnetischen Resonators mit einem elektromagnetischen Hilfsresonator (REM1) umfasst, der so konfiguriert ist, dass er eine höhere Resonanzfrequenz $\omega_1$ und ein höheres Dämpfungsverhältnis aufweist, wobei die Stärke der Kopplung bei einer Frequenz $\omega_c=\omega_1-\omega_0$ moduliert wird.

4. Verfahren nach Anspruch 3, wobei die Kopplung des elektromagnetischen Resonators mit dem elektromagnetischen Hilfsresonator durch ein Gerät des SQUID-Typs (DCS) erfolgt, das eine Schleife umfasst, durch die ein Magnetfeld verläuft, das bei der Frequenz $\omega_c$ moduliert ist.

5. Verfahren nach Anspruch 3, wobei die Kopplung des elektromagnetischen Resonators mit dem elektromagnetischen Hilfsresonator durch einen Josephson-Übergang (JJ) gewährleistet wird, der durch zwei elektromagnetische Signale mit jeweiligen Frequenzen angeregt wird, deren Differenz gleich $\omega_c$ ist.

6. Verfahren nach einem der Ansprüche 3 bis 5, wobei der elektromagnetische Hilfsresonator mit einem Widerstand (R') gekoppelt ist.

7. Verfahren nach einem der vorhergehenden Ansprüche, wobei der elektromagnetische Resonator (REM) vom supraleitenden Typ ist und mikrometrische oder submikrometrische Abmessungen aufweist.

8. Verfahren nach Anspruch 7, wobei der elektromagnetische Resonator in Planartechnologie hergestellt wird.

9. Verfahren nach einem der vorhergehenden Ansprüche, wobei die Spins elektronische Spins sind.

10. Verwendung eines Verfahrens nach Anspruch 9 zum Polarisieren eines Satzes von Kernspins durch dynamische Kernpolarisierung.

11. Vorrichtung zur Hyperpolarisierung von Spins, die Folgendes umfasst:

- eine Quelle (A), die zum Erzeugen eines stationären Magnetfelds ($B_0$) konfiguriert ist;
- einen elektromagnetischen Resonator (REM), der zum Koppeln mit einer Spins (s) enthaltenden Probe (E) und zum Eintauchen in das stationäre Magnetfeld konfiguriert ist, wobei der elektromagnetische Resonator so konfiguriert ist, dass er eine Resonanzfrequenz $\omega_0$ von gleich der Larmorfrequenz der Spins der Probe in dem stationären Magnetfeld hat, wobei die Stärke der Kopplung und der Qualitätsfaktor des Resonators ausreichend hoch sind, damit die Kopplung mit dem Resonator die Relaxationsdynamik der Spins der Probe dominiert; und
- ein Gerät, das zum Reduzieren der effektiven Temperatur

$$T_{eff} = \left[ \frac{k}{\hbar\omega_0} ln\left(1 + \frac{1}{n_{ph}}\right) \right]^{-1}$$

des elektromagnetischen Feldes im Inneren des elektromagnetischen Resonators unter seine physikalische Temperatur konfiguriert ist, wobei $k$ die Boltzmann-Konstante, h die reduzierte Planck-Konstante und $n_{ph}$ die durchschnittliche Anzahl von Photonen der Frequenz $\omega_0$ im Resonator ist.

12. Vorrichtung nach Anspruch 11, wobei das Gerät, das zum Reduzieren der effektiven Temperatur des elektromagnetischen Feldes im Inneren des elektromagnetischen Resonators unter seine physikalische Temperatur konfiguriert ist, einen Widerstand (R), einen zum Halten des Widerstands auf einer Temperatur ($T_0$) unter der ($T_E$) des elektromagnetischen Resonators konfigurierten Kryostaten (CR2) und ein Verbindungselement (EC) umfasst, das zum Überkoppeln des Widerstands mit dem elektromagnetischen Resonator konfiguriert ist.

**13.** Vorrichtung nach Anspruch 11, wobei das Gerät, das zum Reduzieren der effektiven Temperatur des elektromagnetischen Feldes im Inneren des elektromagnetischen Resonators unter seine physikalische Temperatur konfiguriert ist, einen elektromagnetischen Hilfsresonator (REM1), der so konfiguriert ist, dass er eine höhere Resonanzfrequenz $\omega_1$ und ein höheres Dämpfungsverhältnis als der elektromagnetische Resonator aufweist, und eine Kopplungsvorrichtung (DC, DCS, DCJ) umfasst, die zum Koppeln des elektromagnetischen Resonators und des elektromagnetischen Hilfsresonators mit einer Kopplungsstärke konfiguriert ist, die bei einer Frequenz $\omega_c=\omega_1-\omega_0$ moduliert ist.

**14.** Vorrichtung nach Anspruch 13, wobei das Kopplungsgerät (DCS) ein Gerät des SQUID-Typs (DCS) mit einer Schleife und eine Quelle (ANT) für ein magnetisches Wechselfeld umfasst, die zum Erzeugen eines Magnetfeld konfiguriert ist, das bei der Frequenz $\omega_c$ moduliert wird und durch die Schleife verläuft.

**15.** Vorrichtung nach Anspruch 13, wobei das Kopplungsgerät (DCJ) einen Josephson-Übergang (JJ) und zwei elektromagnetische Signalquellen (SRF1, SRF2) mit jeweiligen Frequenzen, deren Differenz gleich $\omega_c$ ist, umfasst, die zum Anregen des Josephson-Übergangs ausgelegt sind.

**16.** Vorrichtung nach einem der Ansprüche 13 bis 15, die auch einen Widerstand (R') umfasst, der mit dem elektromagnetischen Hilfsresonator gekoppelt ist.

**17.** Vorrichtung nach einem der Ansprüche 11 bis 16, wobei der elektromagnetische Resonator (REM) vom Halbleitertyp ist und mikrometrische oder submikrometrische Abmessungen aufweist.

**18.** Vorrichtung nach Anspruch 17, wobei der elektromagnetische Resonator in Planartechnologie ausgeführt ist.

**Claims**

**1.** A method for hyperpolarisation of spins comprising the following steps:

a) placing a sample (E) containing spins (s) in a stationary magnetic field ($B_0$);
b) magnetically coupling the sample to an electromagnetic resonator (REM) configured to have a resonance frequency $\omega_0$ equal to the Larmor frequency of the spins in the stationary magnetic field, with the coupling force and the quality factor of the resonator being high enough so that the coupling with the resonator dominates the relaxation dynamics of the spins; and
c) reducing the effective temperature

$$T_{eff} = \left[ \frac{k}{\hbar \omega_0} ln \left( 1 + \frac{1}{n_{ph}} \right) \right]^{-1}$$

of the electromagnetic field inside the electromagnetic resonator below its physical temperature and that of the sample, with $k$ being the Boltzmann constant, $\hbar$ being the reduced Planck constant and $n_{ph}$ being the average number of photons of frequency $\omega_0$ in the resonator;

as a result of which the polarisation of the spins of the sample is established at a value that is higher than its thermal equilibrium value.

**2.** The method according to claim 1, wherein step c) comprises overcoupling the electromagnetic resonator to a resistor (R) maintained at a temperature lower than that of the electromagnetic resonator and that of the sample.

**3.** The method according to claim 1, wherein step c) comprises coupling the electromagnetic resonator to an auxiliary electromagnetic resonator (REM1) configured to have a resonance frequency $\omega_1$ and a damping ratio that are higher, with the coupling force being modulated at a frequency $\omega_c=\omega_1-\omega_0$.

**4.** The method according to claim 3, wherein coupling the electromagnetic resonator to the auxiliary electromagnetic resonator is implemented using a SQUID (DCS) type device comprising a loop, through which a magnetic field modulated at the frequency $\omega_c$ passes.

**5.** The method according to claim 3, wherein coupling the electromagnetic resonator to the auxiliary electromagnetic resonator is implemented by a Josephson junction (JJ) excited by two electromagnetic signals having respective frequencies, the difference of which is equal to $\omega_c$.

**6.** The method according to any of claims 3 to 5, wherein the auxiliary electromagnetic resonator is coupled to a resistor (R').

**7.** The method according to any of the preceding claims, wherein the electromagnetic resonator (REM) is of the superconductor type and has micrometric or sub-micrometric dimensions.

**8.** The method according to claim 7, wherein the electromagnetic resonator is produced using planar technology.

**9.** The method according to any of the preceding claims, wherein the spins are electron spins.

10. The use of a method according to claim 9 to polarise a set of nuclear spins by dynamic nuclear polarisation.

11. An apparatus for hyperpolarisation of spins comprising:

> - a source (A) configured to generate a stationary magnetic field ($B_0$);
> - an electromagnetic resonator (REM) configured to be coupled to a sample (E) containing spins (s) and to be immersed in the stationary magnetic field, with the electromagnetic resonator being configured to have a resonance frequency $\omega_0$ equal to the Larmor frequency of the spins of the sample in the stationary magnetic field, with the coupling force and the quality factor of the resonator being high enough so that the coupling with the resonator dominates the relaxation dynamics of the spins of the sample; and
> - a device configured to reduce the effective temperature $T_{eff} = \left[ \frac{k}{\hbar\omega_0} ln\left(1 + \frac{1}{n_{ph}}\right) \right]^{-1}$ of the electromagnetic field inside the electromagnetic resonator below its physical temperature, with $k$ being the Boltzmann constant, $\hbar$ being the reduced Planck constant and $n_{ph}$ being the average number of photons of frequency $\omega_0$ in the resonator.

12. The apparatus according to claim 11, wherein the device configured to reduce the effective temperature of the electromagnetic field inside the electromagnetic resonator below its physical temperature comprises a resistor (R), a cryostat (CR2) configured to maintain said resistor at a temperature ($T_0$) below that ($T_E$) of the electromagnetic resonator and a connection element (EC) configured to overcouple the resistor to the electromagnetic resonator.

13. The apparatus according to claim 11, wherein the device configured to reduce the effective temperature of the electromagnetic field inside the electromagnetic resonator below its physical temperature comprises an auxiliary electromagnetic resonator (REM1) configured to have a resonance frequency $\omega_1$ and a damping ratio that are higher than those of the electromagnetic resonator, and a coupling device (DC, DCS, DCJ) configured to couple the electromagnetic resonator and the auxiliary electromagnetic resonator with a coupling force modulated at a frequency $\omega_c = \omega_1 - \omega_0$.

14. The apparatus according to claim 13, wherein the coupling device (DCS) comprises a SQUID (DCS) type device having a loop, and an alternating magnetic field source (ANT) configured to generate a magnetic field modulated at the frequency $\omega_c$ passing through said loop.

15. The apparatus according to claim 13, wherein the coupling device (DCJ) comprises a Josephson junction (JJ) and two electromagnetic signal sources (SRF1, SRF2) having respective frequencies, the difference of which is equal to $\omega_c$, arranged so as to excite said Josephson junction.

16. The apparatus according to any of claims 13 to 15, also comprising a resistor (R') coupled to the auxiliary electromagnetic resonator.

17. The apparatus according to any of claims 11 to 16, wherein the electromagnetic resonator (REM) is of the semiconductor type and has micrometric or sub-micrometric dimensions.

18. The apparatus according to claim 17, wherein the electromagnetic resonator is produced using planar technology.

Fig. 1

$$G(t) = G_0 + \delta G \cos(\omega t)$$

Fig. 2

*Fig. 3A*

*Fig. 3B*

*Fig. 4*

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2016139419 A

**Littérature non-brevet citée dans la description**

- **A. BIENFAIT ; J.J. PLA ; Y. KUBO ; X. ZHOU ; M. STERN ; C.C LO ; C.D. WEIS ; T. SCHENKEL ; D. VION ; D. ESTEVE.** Controlling Spin Relaxation with a Cavity. *Nature,* 2016, vol. 531, 74
- **MARK C. BUTLE ; DANIEL P. WEITEKAMP.** Polarization of nuclear spins by a cold nanoscale resonator. *Phys. Rev. A,* vol. 84, 063407
- **FLORIAN MARQUARDT ; JOE P. CHEN ; A. A. CLERK ; S. M. GIRVIN.** Quantum Theory of Cavity-Assisted Sideband Cooling of Mechanical Motion. *Phys. Rev. Lett.,* vol. 99, 093902
- **W. PFAFF ; C.J. AXLINE ; L. D. BURKHART ; U. VOOL ; P. REINHOLD ; L. FRUNZIO ; L. JIANG ; M. H. DEVORET ; R.J. SCHOELKOPF.** Controlled release of multiphoton quantum states from a microwave cavity memory. *Nature Physics,* 2017, vol. 13, 882-887
- **BIENFAIT, A. ; PLA, J. J. ; KUBO, Y. ; STERN, M. ; ZHOU, X. ; LO, C. C. ; ESTEVE, D.** Reaching the quantum limit of sensitivity in electron spin resonance. *Nature nanotechnology,* 2016, vol. 11 (3), 253-257
- **A. ABRAGAM ; M. GOLDMAN.** Principles of dynamic nuclear polarisation. *Reports on Progress in Physics,* 1978, vol. 41, 395-467